Europäisches Patentamt

European Patent Office

Office européen des brevets

(19)

(11) **EP 1 521 375 A2**

(12) # EUROPEAN PATENT APPLICATION

(43) Date of publication:
06.04.2005 Bulletin 2005/14

(51) Int Cl.[7]: **H03M 13/45**, H03M 13/39

(21) Application number: 04255334.7

(22) Date of filing: 02.09.2004

| | |
|---|---|
| (84) Designated Contracting States: **AT BE BG CH CY CZ DE DK EE ES FI FR GB GR HU IE IT LI LU MC NL PL PT RO SE SI SK TR** Designated Extension States: **AL HR LT LV MK** | (71) Applicant: **Kabushiki Kaisha Toshiba Tokyo 105-8001 (JP)** |
| (30) Priority: **03.10.2003 GB 0323211** **28.07.2004 GB 0416820** | (72) Inventor: **Yee, Mong Suan Bristol BS1 4ND (GB)** |
| | (74) Representative: **Midgley, Jonathan Lee Marks & Clerk 90 Long Acre London WC2E 9RA (GB)** |

(54) **Signal decoding methods and apparatus**

(57)    This invention is generally concerned with methods, apparatus and processor control code for a signal decoding, in particular by employing a plurality of maximum likelihood hard detectors such as sphere decoders.

A decoder for decoding a received signal, said received signal being provided by a transmitted signal comprising a string of symbols sent over a channel, each said symbol comprising one or more bits, said decoder comprising: a plurality of maximum likelihood decoders each configured to determine a minimum bit-dependent distance metric for a string of symbols in which a bit has a defined value, said distance metric being dependent upon a distance of said received signal from an estimated received signal determined from said string and a response of said channel; and a bit likelihood estimator coupled to each of said maximum likelihood estimators and configured to determine a bit likelihood value for each bit of said string dependent upon said minimum distance metrics.

Figure 3a

EP 1 521 375 A2

**Description**

This invention is generally concerned with methods, apparatus and processor control code for a signal decoding, in particular by employing a plurality of maximum likelihood hard detectors such as sphere decoders.

A general problem in the field of signal processing relates to the transmission of a signal from a transmitter to a receiver over a channel, the problem being to determine the transmitted signal from the received signal. The received signal is affected by the channel impulse response or 'memory' of the channel which can cause interference between successively transmitted symbols, and the transmitted signal may also have been encoded prior to sending. A decoder or detector at the receiver has the problem of decoding or detecting the originally transmitted data and/or the original data that has been encoded at the transmitter. The optimum decoder is the *a posteriori* probability (APP) decoder which performs an exhaustive search of all possible transmitted symbols (or strings of transmitted symbols, modifying each by the channel response to determine a set of all possible received signals, and then selecting one or more of these with the closest Euclidian distance to the actually received signal as the most likely transmitted and/or encoded signal(s). However the computational complexity of such an approach grows exponentially with the memory of the encoder, channel impulse response length, number of bits per symbol, and with the number of transmitted symbols (length of string) to consider. Sub-optimal approaches are therefore of technical and commercial interest.

One reduced complexity approximation to the APP solution is the so-called max-log approximation. Broadly speaking determining a bit likelihood value according to this approach involves determining maximum values for two terms, one of which corresponds to the bit having a first logic value, say +1, the other corresponding to the bit having a second logic value, say -1. It has been recognised that maximising each of these terms corresponds to minimising a related distance metric for a candidate string of transmitted symbols, preferably taking into account any *a priori* knowledge which can act as a soft input to the procedure. In embodiments of the invention sphere decoding may be employed to search for a minimum such metric.

There is a continuing need for increased data rate transmission and, equivalently, for more efficient use of available bandwidth at existing data rates. Presently WLAN (wireless local area network) standards such as Hiperlan/2 (in Europe) and IEEE802.1 a (in the USA) provide data rates of up to 54 Mbit/s. The use of multiple transmit and receive antennas has the potential to dramatically increase these data rates, but decoding signals received over a MIMO channel is difficult because a single receive antenna receives signals from all the transmit antennas. A similar problem arises in multi-user systems, although symbols transmitted over the different channels are then uncorrelated. There is therefore a need for improved decoding techniques for MIMO systems. These techniques have applications in wireless LANs, potentially in fourth generation mobile phone networks, and also in many other types of communication system.

Here particular reference will be made to applications involving signals received over a MIMO (multiple-input multiple-output) channel, and to space-time decoding. However embodiments of the invention described herein may also be employed in related systems such as multi-user systems, and for other types of decoding, for example CDMA (code domain multiple access) decoding.

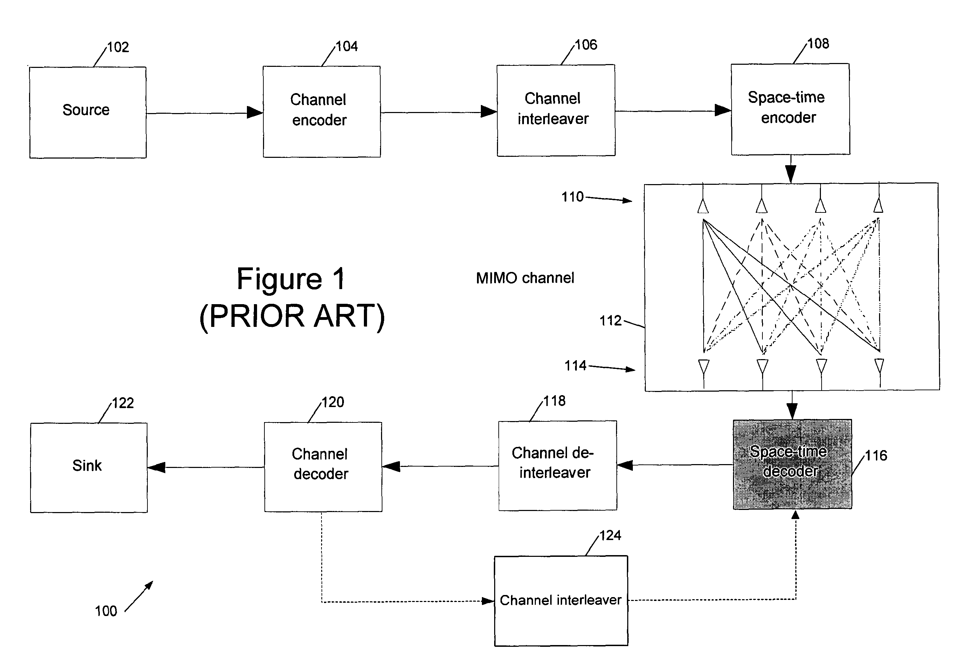

Figure 1 shows a typical MIMO data communications system 100. A data source 102 provides data (comprising information bits or symbols) to a channel encoder 104. The channel encoder typically comprises a convolutional coder such as a recursive systematic convolutional (RSC) encoder, or a stronger so-called turbo encoder (which includes an interleaver). More bits are output than are input, and typically the rate is one half or one third. The channel encoder 104 is followed by a channel interleaver 106 and, in the illustrated example, a space-time encoder 108. The space-time encoder 108 encodes an incoming symbol or symbols as a plurality of code symbols for simultaneous transmission from each of a plurality of transmit antennas 110.

Space-time encoding may be described in terms of an encoding machine, described by a coding matrix, which operates on the data to provide spatial and temporal transmit diversity; this may be followed by a modulator to provide coded symbols for transmission. Space-frequency encoding may additionally (or alternatively) be employed. Thus, broadly speaking, incoming symbols are distributed into a grid having space and time and/or frequency coordinates, for increased diversity. Where space-frequency coding is employed the separate frequency channels may be modulated onto OFDM (orthogonal frequency division multiplexed) carriers, a cyclic prefix generally being added to each transmitted symbol to mitigate the effects of channel dispersion.

The encoded transmitted signals propagate through MIMO channel 112 to receive antennas 114, which provide a plurality of inputs to a space-time (and/or frequency) decoder 116. The decoder has the task of removing the effect of the encoder 108 and the MIMO channel 112, and may be implemented by a sphere decoder. The output of the decoder 116 comprises a plurality of signal streams, one for each transmit antenna, each carrying so-called soft or likelihood data on the probability of a transmitted symbol having a particular value. This data is provided to a channel de-interleaver 118 which reverses the effect of channel interleaver 106, and then to a channel decoder 120, such as a Viterbi decoder, which decodes the convolutional code. Typically channel decoder 120 is a SISO (soft-in soft-out) decoder, that is receiving symbol (or bit) likelihood data and providing similar likelihood data as an output rather than, say, data on which a hard decision has been made. The output of channel decoder 120 is provided to a data sink 122, for further processing of the data in any desired manner.

In some communications systems so-called turbo decoding is employed in which a soft output from channel decoder 120 is provided to a channel interleaver 124, corresponding to channel interleaver 106, which in turn provides soft (likelihood) data to decoder 116 for iterative space-time (and/or frequency) and channel decoding. (It will be appreciated that in such an arrangement channel decoder 120 provides complete transmitted symbols to decoder 116, that is for example including error check bits.)

Here we will consider the general problem of estimating a string of transmitted symbols from a received signal. The string of symbols may be distributed in space, for example across multiple transmit antennas, time (for example with a space time block or trellis coder, and/or frequency, for example where multiple frequency channels or carriers are employed). Embodiments of the techniques described herein are applicable to all these problems.

There are many known types of decoder, for example trellis-based decoders (a variant of the maximum likelihood, ML, approach) such as the Viterbi decoder, linear decoders such as zero-forcing and minimum mean squared error (MMSE) estimators, the vertical-BLAST (Bell labs LAyered Space Time) decoder, and the block decision feedback equaliser.

A sphere decoder can provide performance which approaches that of an APP decoder but at considerably reduced complexity. Broadly speaking candidates for the transmitted signal, modified by the channel response (and space-time encoder) are represented as a lattice in which points correspond to possible (noiseless) received signals. The sphere decoding procedure aims to find one or a few lattice points nearest the actually received signal. The procedure performs a search in a multi-dimensional spherical region centred on the actually received signal. The procedure provides a technique for identifying which lattice points are within the required search radius (which may be adjusted according to the noise level and/or channel conditions). The choice of initial search radius can significantly affect the complexity (number of computations) involved in the procedure.

It is helpful, at this point, to provide an outline review of the operation of the sphere decoding procedure. For a string of $N$ transmitted symbols an $N$-dimensional lattice is searched, beginning with the $N$th dimensional layer (corresponding to the first symbol of the string). A symbol is selected for this layer from the constellation employed and the distance of the generated lattice point from the received signal is checked. If the lattice point is within this distance the procedure then chooses a value for the next symbol in the string and checks the distance of the generated lattice point from the received signal in $N$-1 dimensions. The procedure continues checking each successive symbol in turn, and if all are within the bound it eventually converges on a lattice point in one dimension. If a symbol is outside the chosen radius then the procedure moves back up a layer (dimension) and chooses the next possible symbol in that layer (dimension) for checking. In this way the procedure builds a tree in which the lowest nodes correspond to complete strings of symbols and in which the number of nodes at the nth level of the tree corresponds to the number of lattice points inside the relevant nth dimensional sphere.

When a complete candidate string of symbols is found the distance of the lattice point, generated from the string of symbols, from the received signal is found and the initial radius is reduced to this distance so that as the tree builds only closer strings to the maximum-likelihood solution are identified. When the tree has been completed the decoder can be used to provide a hard output, i.e. the maximum likelihood solution, by choosing the nearest lattice point to the received signal. Alternatively a soft output can be provided using a selection of the closest lattice points to the received signal, for example using the distance of each of these from the received signal as an associated likelihood value.

Background prior art relating to sphere decoding can be found in:

E. Agrell, T. Eriksson, A. Vardy and K. Zeger, "Closest Point Search in Lattices", IEEE Trans. on Information Theory, vol. 48, no. 8, Aug 2002; E. Viterbo and J. Boutros, "A universal lattice code decoder for fading channels", IEEE Trans. Inform. Theory, vol. 45, no. 5, pp. 1639-1642, Jul. 1999; O. Damen, A. Chkeif and J. C. Belfiore, "Lattice code decoder for space-time codes, " IEEE Comms. Letter, vol. 4. no. 5, pp. 161-163, May 2000; B. M. Hochwald and S. T. Brink, "Achieving near capacity on a multiple-antenna channel," htt://mars.bell-labs.com/cm/ms/what/papers/listsphere/, December 2002; H. Vikalo and B. Hassibi, "Low-complexity iterative detection and decoding of multi-antenna systems employing channel and space-time codes", Conference Record of the Thirty-Sixth Asilomar Conference on Signals and Systems and Computers, vol. 1, Nov 3-6, 2002, pp. 294-298; A. Wiesel, X. Mestre, A. Pages and J. R. Fonollosa, "Efficient Implementation of Sphere Demodulation", Proceedings of IV IEEE Signal Processing Advances in Wireless Communications, pp. 535, Rome, June 15-18, 2003; L. Brunel, J. J. Boutros, "Lattice decoding for joint detection in direct-sequence CDMA systems",IEEE Transactions on Information Theory, Volume: 49 Issue: 4 , April 2003, pp. 1030 -1037; US patent application US20030076890, filed on July 26, 2002, to B. M. Hochwald, S. Ten Brink, "Method and apparatus for detection and decoding of signals received from a linear propagation channel", Lucent Technologies, Inc; US patent application US20020114410, filed on August 22, 2002, to L. Brunel, "Multiuser detection method and device in DS-CDMA mode", Mitsubishi Denki Kabushiki Kaisha; H. Vikalo, "Sphere Decoding Algorithms for Digital Communications", PhD Thesis, Standford University, 2003; and B. Hassibi and H. Vikalo, "Maximum-Likelihood Decoding and Integer Least-Squares: The Expected Complexity," in *Multiantenna Channels: Capacity, Coding and Signal Processing,* (editors J. Foschini and S. Verdu).

According to a first aspect of the present invention there is provided a decoder for decoding a received signal, said received signal being provided by a transmitted signal comprising a string of symbols sent over a channel, each said symbol comprising one or more bits, said decoder comprising: a plurality of maximum likelihood decoders each configured to determine a minimum bit-dependent distance metric for a string of symbols in which a bit has a defined value, said distance metric being dependent upon a distance of said received signal from an estimated received signal determined from said string and a response of said channel; and a bit likelihood estimator coupled to each of said maximum likelihood estimators and configured to determine a bit likelihood value for each bit of said string dependent upon said minimum distance metrics.

The maximum likelihood decoders may be implemented in hardware, or software, or a combination of the two; they may, for example, comprise separate instances of a software process. The configuration of the decoder lends itself to a parallel implementation. Moreover embodiments of the decoder provide a soft, likelihood value output based upon, in effect, hard detection decisions, that is without the need to determine many candidates for each possible transmitted symbol. In embodiments the minimum distance metric for a bit is determined for each of the two possible values of the bit and thus only two candidate possibly transmitted symbols are required for each bit of the string. These may be determined by parallel maximum likelihood decoders or a repeated instance of a single decoder. The skilled person will appreciate that, more generally, to implement the plurality of maximum likelihood decoders a single software or hardware molecule may be repeatedly employed to determine the relevant minimum distance metrics.

The distance metric preferably takes account of any available *a priori* knowledge relating to the likelihood of bits and/or symbols of the string to be estimated.

In a preferred embodiment one of the maximum likelihood detectors is configured to determine a maximum likelihood distance metric, in particular a (common) distance metric for each bit of a complete, maximum likelihood string of symbols. One further maximum likelihood detector may then be provided for each bit of the string of symbols, for determining a minimum distance metric for the relevant bit, each of these maximum likelihood decoders determining the distance metric for a value of the bit different to its value in the maximum likelihood string of symbols. Preferably the maximum likelihood string of symbols is determined taking into account *a priori* data relating to the string of symbols, in particular an *a priori* probability value for each bit of the string, thus facilitating a soft input as previously mentioned.

In preferred embodiments the maximum likelihood detectors or decoders comprise sphere decoders. In this case an initial search radius for one or more of the sphere decoders for determining a minimum distance metric for the relevant bit may be determined relative to the distance metric of the maximum likelihood transmitted string of symbols. For example the radius may be set according to a limiting log-likelihood ratio value required by an application. Alternatively where a set of candidate strings of symbols, searched to determine the maximum likelihood transmitted string of symbols and corresponding maximum likelihood distance metrics is determined, one of these can be used to set an initial sphere radius for another of the sphere decoders. In a further alternative a sphere decoder determining a (minimum) distance metric for a particular bit may have its initial radius set to the value of the metric given by the maximum likelihood string of symbols with the relevant particular bit inverted or 'flipped' (that is the bit is given its alternative logic value to the logic value it has in the maximum likelihood string of symbols). The decoder which is configured to determine the maximum likelihood string of symbols is preferably initialised to a sphere radius of infinity so that at least one lattice point will always be found.

In embodiments the channel comprises a MIMO channel and the decoder comprises a MIMO decoder. In other embodiments the symbols of the transmitted string comprise symbols transmitted by different users and the decoder comprises a multi-user decoder or detector. In still other embodiments the decoder comprises a block equaliser for frequency selective fading.

In a related aspect the invention provides a method of decoding a received signal, said received signal being provided by a transmitted signal comprising a string of symbols sent over a channel, each said symbol comprising one or more bits, the method employing a plurality of decoders one allocated to each bit of said string, the method comprising: determining, for each bit of said string using a decoder allocated to the bit, a minimum bit-dependent distance metric for a string of symbols in which a bit has a defined value, said distance metric being dependent upon a distance of said received signal from an estimated received signal determined from said string and a response of said channel; and determining a bit likelihood value for each bit of said string dependent upon said minimum distance metrics.

The invention further provides a decoder configured to implement this method, and a receiver including such a decoder.

The invention further provides a soft-in soft-out decoder for decoding a received signal comprising a set of transmitted symbols, said decoder comprising a plurality of hard decoders each configured to determine a distance metric for a candidate set of said transmitted symbols according to a max-log approximation of a likelihood value of a bit of said set of transmitted symbols, said hard decoders being coupled to an output stage to provide a bit likelihood value for each bit of said set of transmitted symbols responsive to said determined distance metrics.

It will be appreciated that the above described decoders and methods may be employed, for example, in a turbo decoder with iterative block (or other) code decoding and channel decoding.

The skilled person will recognise that the above-described methods and decoders may be implemented using and/or embodied in processor control code. Thus in a further aspect the invention provides such code, for example on a carrier medium such as a disk, CD- or DVD-ROM, programmed memory such as read-only memory (Firmware) or on a data carrier such as an optical or electrical signal carrier. Embodiments of the invention may be implemented on a DSP (Digital Signal Processor), ASIC (Application Specific Integrated Circuit) or FPGA (Field Programmable Gate Array). Thus the code may comprise conventional program code, or micro-code, or, for example, code for setting up or controlling an ASIC or FPGA. In some embodiments the code may comprise code for a hardware description language such as Verilog (Trade Mark) or VHDL (Very high speed integrated circuit Hardware Description Language). As the skilled person will appreciate, processor control code for embodiments of the invention may be distributed between a plurality of coupled components in communication with one another.

These and other aspects of the invention will now be further described, by way of example only, with reference to the accompanying figures in which:

Figure 1 shows an example of a MIMO space-time coded communications system;

Figure 2 shows a block diagram of a first embodiment of a decoder according to an aspect of the present invention;

Figures 3a and 3b show block diagrams of respective second and third embodiments of a decoder according to an aspect of the present invention;

Figure 4 shows a flow diagram of a sphere decoder for use with embodiments of the present invention;

Figure 5 shows a receiver incorporating a decoder configured to operate in accordance with the embodiment of figure 2 and;

Figure 6 shows a graph of bit error rate against signal-to-noise ratio (Eb/No) for an APP max-log MAP decoder and an embodiment of a decoder according to an aspect of the present invention;

Figure 7 shows a set of probability density functions showing number of distance metric calculations on the x-axis and the probability of the number of calculations on the y-axis for a range of signal-to-noise ratios;

Figure 8 shows a set of probability density function curves with the number of distance metric calculations on the x-axis and the probability of the number of calculations on the y-axis for a range of predetermined maximum log likelihood ratio values;

Figure 9 shows a block diagram of a transmitter with concatenated encoders;

Figure 10 shows a block diagram of a receiver with concatenated decoders for use with the transmitter of figure 9;

Figure 11 shows a block diagram of a receiver with concatenated decoders and iterative decoding for use with the transmitter of figure 9; and

Figure 12 shows a block diagram of a receiver employing iterative feedback between two equivalent decoders.

Consider a space-time transmission scheme with $n_T$ transmitted and $n_R$ received signals, for example in a MIMO communications system with $n_T$ transmit and $n_R$ receive antennas. The $1 \times n_R$ received signal vector at each instant time $k$ is given by:

$$\widetilde{\mathbf{r}}_k = \widetilde{\mathbf{s}}_k \widetilde{\mathbf{H}}_k + \widetilde{\mathbf{v}}_k \qquad\qquad \text{Equation 1}$$

where

$$\widetilde{\mathbf{s}}_k = \begin{bmatrix} \widetilde{s}_k^1 & \cdots & \widetilde{s}_k^{n_T} \end{bmatrix}$$

denotes the transmitted vector whose entries are chosen from some complex constellation $C$ with $M = 2^q$ possible signal points and $q$ is the number of bits per constellation symbol. The AWGN (Additive White Gaussian Noise) vector $\widetilde{v}_i$ is a $1 \times n_R$ vector of independent, zero-mean complex Gaussian noise entries with variance of $\sigma^2$ per real component. The notation $\widetilde{H}_i$ denotes an $n_T \times n_R$ multiple-input/multiple-output (MIMO) channel matrix assumed to be known or estimated at the receiver, with $n$-row and $m$-column components $h_{n,m}$, $n = 1, \ldots, n_T$, $m = 1, \ldots, n_R$, representing the narrowband flat fading between the $n$-th transmitted signal and $m$-th received signal. The channel fade may be assumed to be constant over a symbol period.

In a receiver a MIMO channel estimate $\widetilde{H}_i$ can be obtained in a conventional manner using a training sequence. For example a training sequence can be transmitted from each transmit antenna in turn (to avoid interference problems), each time listening on all the receive antennas to characterise the channels from that transmit antenna to the receive antennas. (This need not constitute a significant overhead and data rates are high in between training and, for example, with slowly changing indoor channels training may only be performed every, say, 0.1 seconds). Alternatively orthogonal sequences may be transmitted simultaneously from all the transmit antennas, although this increases the complexity of the training as interference problems can than arise.

All linear space-time block coded transmission schemes can be written in the form of Equation 1. For example, BLAST (G. J. Foschini, "Layered space-time architecture for wireless communication in a fading environment when using multi-element antennas," Bell Labs. Tech. J., vol. 1, no. 2, pp. 41-59, 1996) uses the transmit antennas to send a layered structure of signals, and therefore $n_T$ represents the number of transmit antennas, $n_R$ represents the number of receive antennas and $\widetilde{H}_i$ is the true MIMO channel matrix. Other examples include orthogonal designs (S. M. Alamouti, "A simple transmitter diversity scheme for wireless communications," IEEE J. Sel. Area Comm., pp. 1451-1458, Oct. 1998; and V. Tarokh, H. Jafarkhani and A. R. Calderbank, "Space-time block codes from orthogonal designs," IEEE Trans. Info. Theory., vol. 45, pp. 1456-1467, July 1999) and linear dispersive codes (B. Hassibi and B. Hochwald, "High-rate codes that are linear in space and time," IEEE Trans. Info. Theory., vol. 48, pp. 1804-1824, Jul. 2002), where $\widetilde{H}_i$ is an effective channel derived from one or more uses of the true channel.

Equation 1 may also be used to represent a CDMA system where the multi-user detector estimates the signal $\widetilde{s}_i$ transmitted from different users and matrix $\widetilde{H}_i$ represents the combined spreading and channel effects for all users.

Ignoring the time index $k$ for simplicity of discussion, the $n$-th component of the transmitted symbol $\widetilde{s}$ is obtained using the symbol mapping function

$$\widetilde{s}^n = map(\mathbf{x}^n), \qquad n = 1, \cdots, n_T \qquad \text{Equation 2}$$

where

$$\mathbf{x}^n = \begin{vmatrix} x_1^n & \cdots & x_q^n \end{vmatrix} \qquad \text{Equation 3}$$

is a vector with $q$ transmitted data bits, and $q$ is the number of bits per constellation symbol. (More generally, however, $\widetilde{s}$ denotes a string of symbols encoded over space and/or time and/or frequency and $n$ runs over the length of the string). Therefore the $(q \cdot n_T)$-length vector of bits transmitted can be denoted by

$$\mathbf{x} = [\mathbf{x}^1 \cdots \mathbf{x}^{n_T}] \qquad \text{Equation 4}$$

and the transmitted vector constellation is written as

$$\widetilde{\mathbf{s}} = map(\mathbf{x}).$$

The complex matrix representation of Equation 1 (ignoring the time index $k$) can be transformed to a real matrix representation with twice the dimension of the original system as follows:

$$r = sH + v \qquad \text{Equation 5}$$

where

$$\mathbf{r} = \left[ \Re\{\tilde{\mathbf{r}}\} \quad \Im\{\tilde{\mathbf{r}}\} \right] \qquad \text{Equation 6}$$

$$\mathbf{s}_k = \left[ \Re\{\tilde{\mathbf{s}}\} \quad \Im\{\tilde{\mathbf{s}}\} \right] \qquad \text{Equation 7}$$

$$\mathbf{H} = \begin{bmatrix} \Re\{\tilde{\mathbf{H}}\} & \Im\{\tilde{\mathbf{H}}\} \\ -\Im\{\tilde{\mathbf{H}}\} & \Re\{\tilde{\mathbf{H}}\} \end{bmatrix} \qquad \text{Equation 8}$$

$$\mathbf{v} = \left[ \Re\{\tilde{\mathbf{v}}\} \quad \Im\{\tilde{\mathbf{v}}\} \right] \qquad \text{Equation 9}$$

We shall use the real-valued representation of Equation 5 to Equation 9 in the following discussion so that, for example, **r** and **s** are real vectors and **H** is a real matrix.

The maximum *a posteriori* probability (APP) bit detection, conditioned on the received signal r for the space-time transmission of Equation 5 can be expressed in log likelihood ratio (LLR) terms as follows:

$$L_P\left(x_j^n \mid \mathbf{r}\right) = \ln \frac{P(x_j^n = +1 \mid \mathbf{r})}{P(x_j^n = -1 \mid \mathbf{r})}$$

$$= \ln \frac{\displaystyle\sum_{\mathbf{x} \in X_{n,j}^+} \exp\left(-\frac{1}{2\sigma^2} \cdot \left\|\mathbf{r} - \hat{\mathbf{s}}\mathbf{H}\right\|^2 + \frac{1}{2} \cdot \mathbf{x}^T \cdot \mathbf{L}_A\right)}{\displaystyle\sum_{\mathbf{x} \in X_{n,j}^-} \exp\left(-\frac{1}{2\sigma^2} \cdot \left\|\mathbf{r} - \hat{\mathbf{s}}\mathbf{H}\right\|^2 + \frac{1}{2} \cdot \mathbf{x}^T \cdot \mathbf{L}_A\right)}$$

$$= L_A\left(x_j^n\right)$$

$$+ \ln \underbrace{\frac{\displaystyle\sum_{\mathbf{x} \in X_{n,j}^+} \exp\left(-\frac{1}{2\sigma^2} \cdot \left\|\mathbf{r} - \hat{\mathbf{s}}\mathbf{H}\right\|^2 + \frac{1}{2} \cdot \mathbf{x}_{[n,j]}^T \cdot \mathbf{L}_{A,[n,j]}\right)}{\displaystyle\sum_{\mathbf{x} \in X_{n,j}^-} \exp\left(-\frac{1}{2\sigma^2} \cdot \left\|\mathbf{r} - \hat{\mathbf{s}}\mathbf{H}\right\|^2 + \frac{1}{2} \cdot \mathbf{x}_{[n,j]}^T \cdot \mathbf{L}_{A,[n,j]}\right)}}_{L_E\left(x_j^n \mid \mathbf{r}\right)}$$

$$n = 1, \cdots, n_T \qquad j = 1, \cdots, q \qquad\qquad \text{Equation 10}$$

where $\mathbf{x}$ is a sequence of possible transmitted bits, $\mathbf{L}_A$ is a vector of $L_A$-values of $\mathbf{x}$, $\hat{\mathbf{s}}$ is a vector of possible transmitted symbols, i.e. $\hat{\mathbf{s}} = map(\mathbf{x})$, $\mathbf{x}_{[n,j]}$ denotes the sub vector of $\mathbf{x}$ obtained by omitting its element $x_j^n$, and $\mathbf{L}_{A,[n,j]}$ denotes the vector of all $L_A$-values, also omitting the element corresponding to bit $x_j^n$; and where $\|\cdot\|$ denotes the Euclidean norm. The set $X_{n,j}^+$ is the set of $2^{(q \cdot n_T - 1)}$ bit vectors $\mathbf{x}$ having $x_j^n = +1$, i.e.

$$X_{n,j}^+ = \left| \mathbf{x} \mid x_j^n = +1 \right|$$

and

$$X_{n,j}^- = \left| \mathbf{x} \mid x_j^n = -1 \right|.$$

The symbol $\hat{\mathbf{s}}$ is the mapping to the possible transmitted bit vector $\mathbf{x}$. The functions $L_P\,(\cdot)$, $L_A\,(\cdot)$ and $L_E(\cdot)$ denote the *a posteriori*, *a priori* and extrinsic likelihood ratio respectively.

According to Equation 10 APP detection requires an exhaustive evaluation of $2^{q \cdot n_T}$ distance metrics $\|\mathbf{r} - \hat{\mathbf{s}}\mathbf{H}\|^2$ corresponding to the number of elements in the set $X_{n,j}^+$ and $X_{n,j}^-$. The computational complexity of APP detection increases exponentially with the number of bits per symbol q and number of spatial-multiplexed transmitted symbols $n_T$.

Here we describe an efficient method to evaluate the max-log approximation of Equation 10 for each bit $x_j^n$:

$$L_P\left(x_j^n \mid \mathbf{r}\right) \approx \frac{1}{2}\max_{\mathbf{x}\in X_{n,j}^+}\left\{-\frac{1}{\sigma^2}\cdot\left\|\mathbf{r}-\hat{\mathbf{s}}\mathbf{H}\right\|^2 + \mathbf{x}^T\cdot\mathbf{L}_A\right\}$$
$$\underbrace{-\frac{1}{2}\max_{\mathbf{x}\in X_{n,j}^-}\left\{-\frac{1}{\sigma^2}\cdot\left\|\mathbf{r}-\hat{\mathbf{s}}\mathbf{H}\right\|^2 + \mathbf{x}^T\cdot\mathbf{L}_A\right\}}_{\text{max}-\text{log approximation}}$$
$$n = 1,\cdots,n_T \qquad j = 1,\cdots,q$$

Equation 11

by searching for the candidates that provide the max{·} term for $\mathbf{x}\in X_{n,j}^+$ and $\mathbf{x}\in X_{n,j}^-$ for each transmitted bit without exhaustively evaluating the term $-\frac{1}{\sigma^2}\cdot\|\mathbf{r}-\hat{\mathbf{s}}\mathbf{H}\|^2 + \mathbf{x}^T\cdot\mathbf{L}_A$ in Equation 11 for all possible $\hat{\mathbf{s}}$. Note that since there are $(q\cdot n_T)$ transmitted bits, there $(q\cdot n_T)$ operations which evaluate Equation 11.

An embodiment of the invention uses a sphere decoder search algorithm (see, for example, Viterbo and Boutros, *ibid,* hereby incorporated by reference) to search for the candidates **s** that satisfy the condition

$$\|\mathbf{r}-\hat{\mathbf{s}}\mathbf{H}\|^2 - \sigma^2\mathbf{x}^T\cdot\mathbf{L}_A \le \rho^2$$

Equation 12

For every candidate found, the bound $\rho^2$ is reduced until one candidate is found that satisfies the minimum metric $\|\mathbf{r}-\mathbf{s}\mathbf{H}\|^2 - \sigma^2\mathbf{x}^T\cdot\mathbf{L}_A$ for a particular bit.

The sphere decoding procedure is well known to the skilled person. In outline, the procedure comprises three main processes:

i) Transformation of the multiple-input-multiple-output (MIMO) channel into a lattice representation.

ii) The search procedure, which searches for the nearest lattice point to the received signal in the case of hard detection or the set of lattice points around the received signal in the case of soft detection. Where a soft input is available, providing an *a priori* probability of a transmitted symbol or codeword, this can be utilised to assist the search (see also, for example, H. Vikalo and B. Hassibi, "Low-Complexity Iterative Detection and Decoding of Multi-Antenna Systems Employing Channel and Space-Time Codes," Conference Record of the Thirty-Sixth Asilomar Conference on Signals, Systems and Computers, vol. 1, Nov. 3-6, 2002, pp. 294-298; and H. Vikalo and B. Hassibi, "Towards Closing the Capacity Gap on Multiple Antenna Channels", ICASSP'02, vol. 3, pp. III-2385 - III-2388).

iii) Where a soft output is needed, providing the soft output based on the soft input and the set of lattice points found in the search region.

An *n*-dimensional lattice can be decomposed into (*n*-1) dimensional layers. The search algorithm for a *n* dimensional lattice can be described recursively as a finite number of (*n*-1) -dimensional search algorithms. Viterbo and Boutros (*ibid*) described the search algorithm in terms of three different states, or cases, of the search:

Table 1

| | |
|---|---|
| **Case A** | The *n*-th dimensional layer is within the search bound: The layer is decomposed into (*n-1*)-th dimensional layers. |
| **Case B** | The search succesfully reaches the zero-dimensional layer and a lattice point in the search region is found |
| **Case C** | The *n*-th dimensional layer is not within the search bound: The search moves up one step in the hierarchy of layers. |

Broadly speaking the lattice search involves selecting a candidate symbol for a string of symbols (vector $\hat{\mathbf{s}}$), testing an inequality to determine whether the $k$-th dimensional "layer" is within the search bound, and if so selecting the next symbol. After a component of a vector **s** that satisfies the distance metric is found its contribution is subtracted. In this way the search, in effect, constructs a tree with one or more lattice points at the end node(s) ("zero dimensional layer"). The lattice point with the smallest distance metric provides the hard decision output (for that metric).

The search procedure is simplified if the lower triangular matrix $\mathbf{U}^T$, derived from QR decomposition or Cholesky factorisation (sometimes referred to as taking the square root of a matrix) of the channel matrix, is used as the generator matrix. For example, if QR decomposition is used (see, for example, G.H. Golub and C.F. van Loan, Matrix Computations, John Hopkins University Press, 1983), the lower triangular matrix $\mathbf{U}^T$ (and upper $\mathbf{U}$) are defined by $\mathbf{U}^T\mathbf{U} = \mathbf{H}^T\mathbf{H}.$

Having briefly described the concept of the sphere decoder, we will now describe how this (and other decoding procedures) can be applied to provide an improved, max-log MAP (maximum *a posteriori* probability) based decoder. Thus here we provide a max-log-MAP solution by searching for the two candidates that satisfy the max $\{\cdot\}$ term in Equation 11. Therefore, the search procedure is performed for every bit $x_j^n$ to find the two candidates that satisfy the following optimisations:

$$\hat{\mathbf{s}}^+ = \min_{\hat{\mathbf{s}} \in X_{n,j}^+} \left\{ \left\| \mathbf{r} - \hat{\mathbf{s}}\mathbf{H} \right\|^2 - \sigma^2 \mathbf{x}^T \cdot \mathbf{L}_A \right\}$$

for bit $x_j^n = +1$ and

$$\hat{\mathbf{s}}^- = \min_{\hat{\mathbf{s}} \in X_{n,j}^-} \left\{ \left\| \mathbf{r} - \hat{\mathbf{s}}\mathbf{H} \right\|^2 - \sigma^2 \mathbf{x}^T \cdot \mathbf{L}_A \right\}$$

for bit $x_j^n = -1$, where $n = 1, ..., n_T$ and $j = 1, \cdots, q$. The corresponding distance metrics are obtained for the two candidates, $d_{n,j,+}^2$ and $d_{n,j,-}^2$ where

$$d_{n,j,+}^2 = \left| r - \hat{s}^+ H \right|^2 - \sigma^2 x^{+T} \cdot L_A^+ \qquad \text{Equation 13}$$

and

$$d_{n,j,-}^2 = \left| r - \hat{s}^- H \right|^2 - \sigma^2 x^{-T} \cdot L_A^- \qquad \text{Equation 14}$$

The vectors $\mathbf{x}^+$, $\mathbf{x}^-$ and $\mathbf{L}^+_A, \mathbf{L}^-_A$ correspond to the bit sequences and a priori information of the symbols $\hat{\mathbf{s}}^+$ and $\mathbf{s}^-$.

Therefore, the max-log-MAP approximation of the extrinsic LLR (log likelihood ratio) value is given by:

$$L_P\left(x_j^n \mid \mathbf{r}\right) \approx \underbrace{\frac{1}{2\sigma^2}\left(-d_{n,j,+}^2 + d_{n,j,-}^2\right)}_{\text{max} - \text{log approximation}} \qquad \text{Equation 15}$$

The relationship between $L_P$ and $L_E$ is given by $L_P = L_A + L_E$.

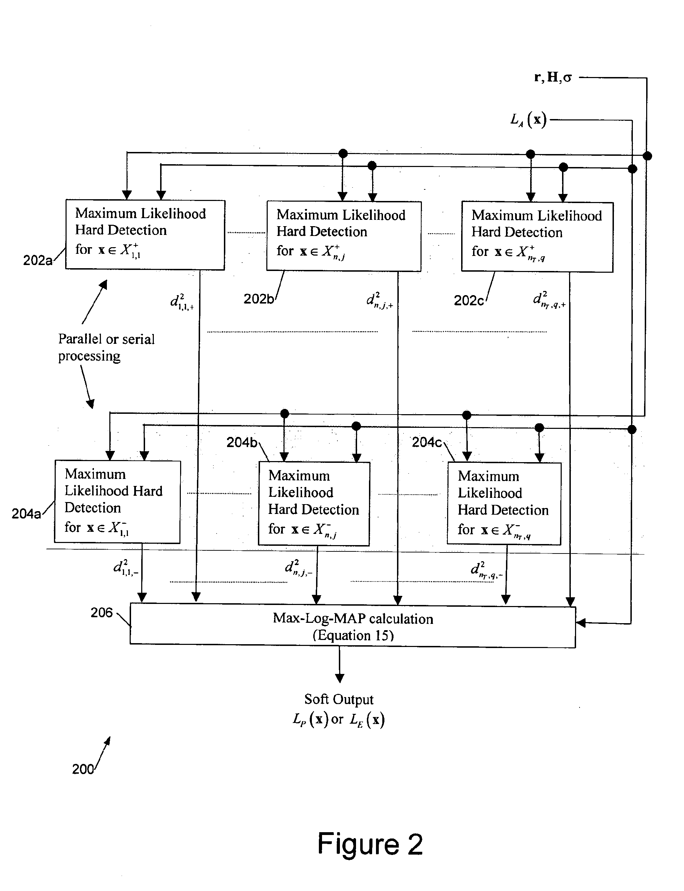

Referring to Figure 2, this shows a block diagram of a max-log MAP decoder 200 configured to determine bit likelihood values in accordance with the max-log approximation of Equation 15. The decoder comprises a plurality of hard detectors or decoders 202a-c, 204a-c, each configured to determine a distance metric $d_{n,j,+}^2$, $d_{n,j,-}^2$ for a possible value of a particular bit $x_j^n$, +1 for detectors/decoders 202, -1 for detectors/decoders 204, according to respective equations 13 and 14, based upon input values for $\mathbf{r}, \mathbf{H}, \sigma$ and, where available, $L_A(\mathbf{x})$. In this embodiment $n$ runs over the transmit antennas and $j$ runs over the bits of a constellation symbol. Each of these detectors/decoders 202,204 provides a distance metric value $d^2_{n,j,+}$, $d^2_{n,j,-}$ to an output stage 206 that determines a bit likelihood value for each bit of the transmitted string of symbols according to Equation 15. The likelihood values may comprise "extrinsic" and/or *a posteriori* bit likelihood values. The skilled person will appreciate that the detectors/decoders 202,204 may be implemented in series, for example as repeated instances of a software process, or in parallel, or in a combination of serial and parallel processes.

The noise variance may be obtained in any convenient manner, depending upon the overall system design. For example, the noise variance may be obtained during the training period where channel impulse response is estimated. During the training period, the transmitted symbol sequence is known. Together with the estimated channel impulse response, the 'noiseless' received signal is obtained. The noise variance may be estimated from evaluating the noise statistic of the sequence of received signal during the 'training period', knowing the sequence of 'noiseless' received signal.

A detector/decoder 202,204 need only provide a hard output, that is an output identifying a most likely candidate with a particular bit value $x^n_j$ being + 1 or -1 and/or providing a minimum distance metric $d^2_{n,j,+}$ or $d^2_{n,j,-}$. Thus the skilled person will appreciate that the arrangement of Figure 2 may employ any maximum likelihood hard detectors/decoders that can provide the appropriate distance metrics. However in a preferred embodiment hard detectors/decoders 202,204 are implemented using one or more sphere decoders.

For the received vector $\mathbf{r}$, either candidate $\hat{\mathbf{s}}^+$ or $\hat{\mathbf{s}}^-$ is the maximum likelihood estimate $\hat{\mathbf{s}}_{ML}$ - that is the maximum likelihood solution provides one set of bit values $\mathbf{X}_{ML}$ and corresponding distance metrics $d^2_{ML}$. Thus maximum likelihood sphere decoding can be performed first and the bit-wise sphere decoding may then be performed to obtain the distance metrics, $d^2_{n,j,\neq ML}$, for the bit values which do not correspond to the maximum likelihood symbol estimate.

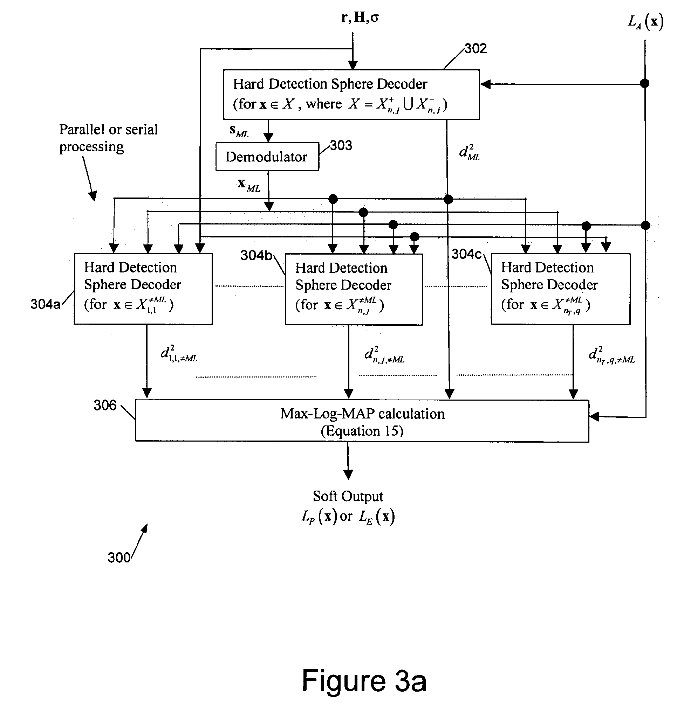

Figure 3a shows a block diagram of a max-log decoder 300 configured to determine bit likelihood values in this way, and employing sphere decoders as hard detectors. In Figure 3a hard detection blocks 304a-c and output stage 306 correspond to a combination of detectors/decoders 202 and 204 which correspond to the set of non-maximum-likelihood bit sequence $\mathbf{x} \in X^{\neq ML}_{n,j}$ and to output stage 206 of Figure 2 respectively. An additional hard detector 302, preferably a sphere decoder, determines a maximum likelihood symbol string estimate $\hat{\mathbf{s}}_{ML}$ and a demodulator 303 converts this symbol estimate to a bitwise estimate $\mathbf{x}_{ML}$; hard detection sphere decoder 302 also provides a corresponding bit likelihood value $d^2_{ML}$ (common to all the bits of $\mathbf{x}_{ML}$).

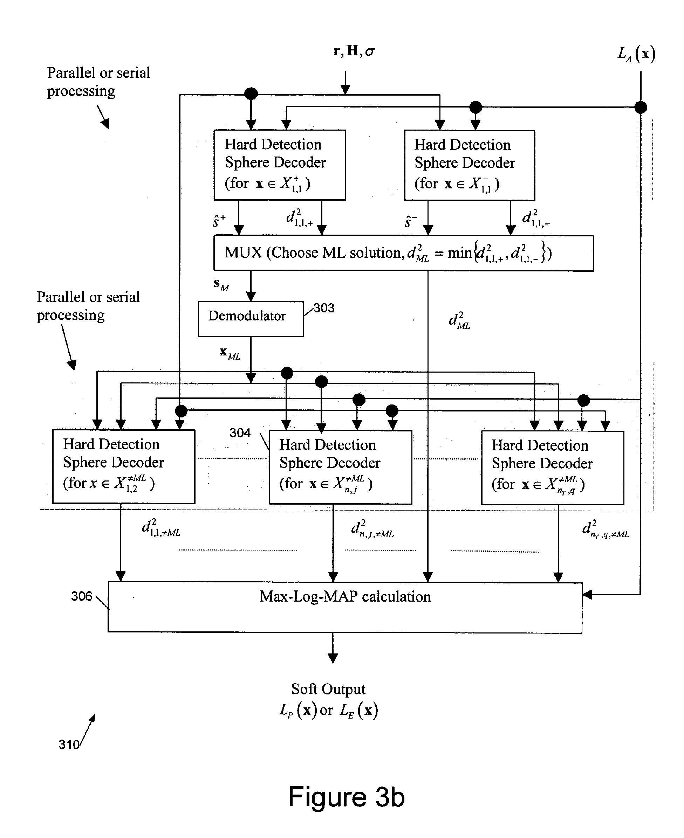

Figure 3b shows a block diagram of another embodiment of a two-stage max-log-MAP sphere decoder 310, in which similar elements to those of Figure 3a are indicated by like reference numerals. In the decoder of Figure 3b the first stage comprises two maximum likelihood decoders configured to determine a minimum distance metric for a predetermined bit (the first bit), each of these maximum likelihood decoders determining a distance metric for the predetermined bit (the first bit) having one of a first and second logic level. Here, a string of symbols corresponding to the shorter distance metric provides the maximum likelihood transmitted symbols. The second stage comprises further maximum likelihood detectors, provided for each other (subsequent) bit, each of these maximum likelihood decoders determining a distance metric for a value of the bit different to its value in the maximum likelihood string of symbols. Either or both stages of the maximum likelihood detector may be implemented using parallel processing.

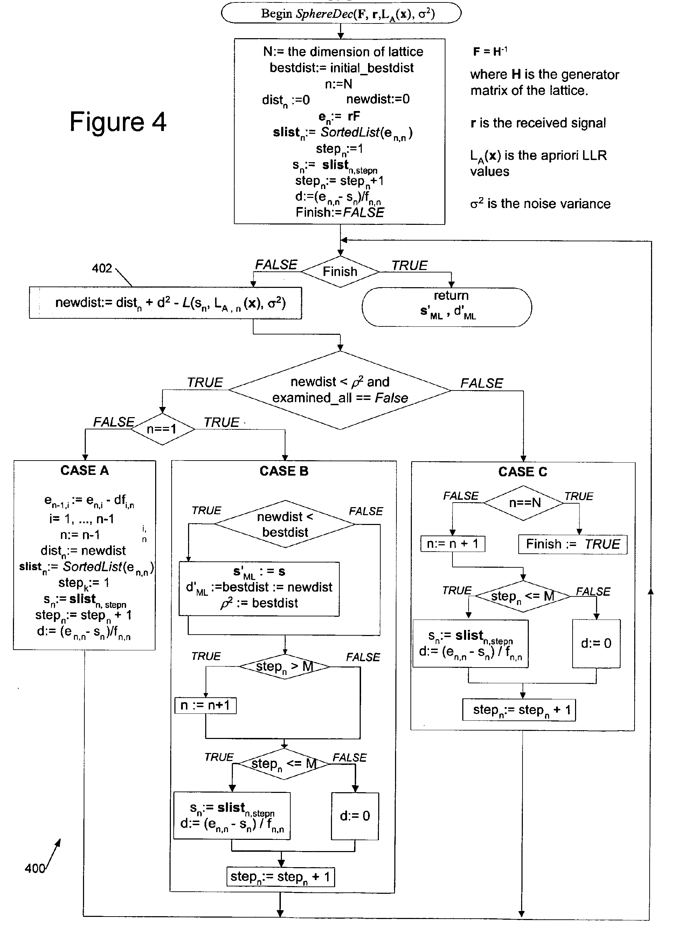

Figure 4 shows a flow diagram 400 of a sphere decoding procedure for implementing a maximum likelihood hard detector such as one of detectors/decoders 202,204 of Figure 2 or one of the detectors/decoders of Figure 3a or 3b. The procedure is a modification of a conventional sphere decoding procedure and, in particular of the distance metric calculation at step 402. In a conventional procedure (for example to implement maximum likelihood sphere decoder 302 of Figure 3a) that does not consider the available soft input, the final term in the update of the distance metric performed at step 402 is missing. In the procedure of Figure 4 the function $L(\cdot)$ provides the a priori LLR term in the distance metric given in Equation 12 for symbol $s_n$, that is

$$\mathrm{L}(s_n, L_A(\mathbf{x}_n), \sigma^2) = \sigma^2 \mathbf{x}_n^T \mathbf{L}_{A,n}$$

and $\mathbf{x}_n$ is obtained from the relationship $s_n = map(\mathbf{x}_n)$.

Referring in more detail to Figure 4, the generator matrix of the lattice $\mathbf{H}$ ($\mathbf{F} = \mathbf{H}^{-1}$ where $\mathbf{F}$ is a triangular matrix and $\mathbf{H}$ is pre-processed to be a triangular matrix, for example using QR decomposition) is the lattice representation of the communication system and the received signal is **r** (pre-processed in the same way as the generator matrix for the search procedure); $L_A(\mathbf{x})$ comprises the a priori LLR values and $\sigma^2$ is the noise variance. The outputs of the procedure are $\mathbf{s'}_{ML}$ and $d'_{ML}$ where the sphere decoding is performed for the set of bit sequence in the set $X$, $X_{n,j}^{\neq ML}$, $X_{n,j}^{+}$ or $X_{n,j}^{-}$. The output $\mathbf{s'}_{ML}$ is the lattice input corresponds to the lattice point closest to the received signal **r** rand is the maximum likelihood solution. The output $d'_{ML}$ is the distance metrics corresponding to the lattice inputs $\mathbf{s'}_{ML}$. The output $d'_{ML}$ refers to the sphere decoding output $d^2_{n,j,+}$ for $\mathbf{x} \in X_{n,j}^{+}$ in 202, $d^2_{n,j,-}$ for $\mathbf{x} \in X_{n,j}^{-}$ in 204, $d^2_{ML}$ for $\mathbf{x} \in X$ in 302 and $d^2_{n,j,\neq ML}$ for $\mathbf{x} \in X_{n,j}^{\neq ML}$ in 304. The search region is defined by the search radius $\rho^2$. For most applications the variable initial _bestdist is assigned to a large value.

The function *SortedList($e_{n,n}$)* provides an ordered set of lattice inputs to be searched according to an increasing distance from $e_{n,n}$ and $M$ is the number of lattice inputs (the number of possible symbols in the constellation) to be searched through and is the length of the vector **slist$_n$** (**slist** is a $N \times M$ matrix, and step$_n$ counts from 1 to $M$). The ordering may thus be performed using a look up table storing all the possible combinations, for example, using a $c \times M$ matrix $\Phi$ where $c = 2M$ is the number of symbol search combinations. The sorted vector **slist** for the zero-forcing solution s''$^n$ (where the zero-forcing solution **s''** is given by **s''** = $(\mathbf{H}^T\mathbf{H})^{-1}\mathbf{H}^T\mathbf{r}$) is given as the $i$-th row of $\Phi$, **slist** = $\Phi(i)$ where $i = \lceil s''^n \rceil + M - 1$ and $\lceil . \rceil$ denotes rounding towards infinity. The notation **slist$_{n,i}$** refers to the ith element of the vector **slist$_n$**. Broadly speaking this technique comprises a modified version of the Schnorr-Euchner strategy described in Agrell et al. *(ibid).* The zero-forcing solution at the $n$ th dimensional search is given by $e_n := \mathbf{rF}$. The number of unknowns (length of the string of symbols to be estimated) is N (bearing in mind that where I and Q components are to be estimated there are two unknowns per symbol so that the number of unknowns doubles).

The three Cases A, B and C are as described above; broadly speaking the procedure initialises n = N and examines symbols, preferably in **slist** order, until all have been examined (examined_all is true when all symbols in **slist$_n$** have been examined at the $n$th dimensional search), moving up a layer (Case C) when outside the search radius $\rho^2$ and finishing when back at the top of the tree (when n is equal to N).

Methods for ordering the symbols to be searched using look-up table are described in more detail in A. Wiesel, X. Mestre, A. Pages and J. R. Fonollosa, "Efficient Implementation of Sphere Demodulation", Proceedings of IV IEEE Signal Processing Advances in Wireless Communications, pp. 535, Rome, June 15-18, 2003, which is hereby incorporated by reference.

To illustrate the operation of the decoder of Figure 3a consider an example. We take the case of a two transmit antenna system with a 4 PAM (Pulse Amplitude Modulation) symbol constellation, $C = \{-3,-1,1,3\}$, corresponding to the symbol mapping of the bits $\{-1\ -1, -1\ +1, +1\ +1, +1\ -1\}$, where the maximum likelihood estimate is found to be $\mathbf{s}_{ML}$ = [-1 3] with $\mathbf{x}_{ML}$ = [-1 +1 +1 -1] and distance metric $d^2_{ML}$. In this example, therefore, bit-wise sphere decoding is performed for the set $X_{1,1}^{+}, X_{1,2}^{-}, X_{2,1}^{-}, X_{2,2}^{+}$ to obtain the distance metrics $d^2_{1,1,\neq ML} = d^2_{1,1,+}$, $d^2_{1,2\neq ML} = d^2_{1,2,-}$, $d^2_{2,1,\neq ML} = d^2_{2,1,-}$ and $d^2_{2,2,\neq ML} = d^2_{2,2,+}$ since $d^2_{1,1,-} = d^2_{1,2,+} = d^2_{2,1,+} = d^2_{2,2,-} = d^2_{ML}$.

It can be seen that the bit-wise sphere decoding can be performed in parallel, facilitating a fast hardware implementation.

In order to increase the speed of the bit-wise sphere decoding after obtaining the maximum likelihood distance metrics $d^2_{ML}$, the initial search radius of the bit-wise sphere decoding can be pre-determined. We now describe some methods for achieving this.

The initial search region of the bit-wise sphere decoding can be bounded according to the maximum extrinsic LLR magnitude $|L_P|_{MAX}$ required by an application. This may be preset to a particular value, for example 50. Here, the value $|L_P|_{MAX}$ becomes a parameter of the max-log MAP sphere decoder. Therefore, referring to Equation 15, the initial sphere radius of the bit-wise sphere decoder may be set as follows:

$$\rho^2_{initial} = 2\sigma^2|L_P|_{MAX} + d^2_{ML} \qquad\qquad \text{Equation 16}$$

This may be obtained by limiting the maximum magnitude (i.e. irrespective of sign) of $L_P(x_j^n|\mathbf{r})$ to $|L_P|_{MAX}$.

Another approach potentially provides a greater increase in the speed of the bit-wise sphere decoding. The list of candidates $\{\mathbf{s}_1, \mathbf{s}_2,...,\mathbf{s}_P\}$ searched by the maximum likelihood sphere decoder, together with their distance metrics $\{d^2_1, d^2_2, \cdots, d^2_P\}$, can be used to set the initial sphere radius $\rho^2_{n,j,initial}$ of the bit-wise sphere decoders if $d^2_i < \rho^2_{initial}$, $i$ =

1,..., $P$. Mapping of the initial sphere radius $\rho^2_{n,j,initial}$ , $n = 1,\cdots, n_T$, $j = 1,\cdots, q$ , to the distance metrics $\{d^2_1, d^2_2, \cdots, d^2_P\}$ where $d^2_i < \rho^2_{initial}$, is performed. For example where maximum likelihood sphere decoding is performed, the symbol set $\{\hat{\mathbf{s}}_1, \hat{\mathbf{s}}_2, \cdots, \hat{\mathbf{s}}_{10}\}$ is searched and solution for bit $x^2_1$ is found to be -1. The subset of the searched symbols $\{\hat{\mathbf{s}}_1, \hat{\mathbf{s}}_5, \hat{\mathbf{s}}_7\}$ is found to have the bit $x^2_1 = +1$ and the corresponding distance metrics is found to have the relative magnitude $d_5 < \rho_{initial} < d_1 < d_7$. The initial radius for bitwise sphere decoding of bit $x^2_1$ is therefore given as $\rho^2_{2,1,initial} = d^2_7$. Some of the initial sphere radii will not have a mapping to the distance metrics $\{d^2_1, d^2_2, \cdots, d^2_P\}$ and they may be set to $\rho^2_{initial}$ from Equation 16.

In another alternative approach the sphere radius of the bit-wise sphere decoder is be set to the distance metric of the maximum likelihood bit sequence with the sign of the bit to be detected changed or 'flipped', that is using Equation 17 below:

$$\rho^2_{n,j,initial} = \left\| r - \hat{s}_{n,j,flipped} \, H \right\|^2 - \sigma^2 x^T \cdot L_A \qquad\qquad \text{Equation 17}$$

where $\hat{\mathbf{s}}_{n,j,flipped}$ is the maximum likelihood symbol detected but with the maximum likelihood bit $x^n_j$ being 'flipped' or inverted (for example from +1 to -1 and vice versa). The vectors **x** and $\mathbf{L}_A$ are the bit sequence and the corresponding a priori LLR vector, respectively, for the symbol $\hat{\mathbf{s}}_{n,j,flipped}$ .

Using the previous example where the maximum likelihood bit sequence detected is $\mathbf{x}_{ML} = [-1 \ +1 \ +1 \ -1]$, the initial sphere radius $\rho^2_{n,j,initial}$ of the bit-wise sphere decoder is obtained according to Equation 17 with the symbol $\hat{\mathbf{s}}_{n,j,flipped}$ as follows:

$$\hat{s}_{1,1,flipped} = map([+1 \ +1 \ +1 \ -1]) = [1 \ 3],$$

$$\hat{s}_{1,2,flipped} = map([-1 \ -1 \ +1 \ -1]) = [-3 \ 3],$$

$$\hat{s}_{2,1,flipped} = map([-1 \ +1 \ -1 \ -1]) = [-1 \ -3],$$

$$\hat{s}_{2,2\,flipped} = map([-1 \ +1 \ +1 \ +1]) = [-1 \ 1].$$

In a particularly preferred approach, which may be applied in addition to the above described techniques, the search process is bounded as described in more detail in the Applicant's co-pending UK patent application no. 0323208.9 filed 3 Oct 2003 (and also in corresponding applications claiming priority from this UK application), the contents of which are hereby incorporated by reference in their entirety. In particular candidate symbol searching in the sphere decoding process may be stopped after a (predetermined) limiting number of symbols have been examined/ distance determinations have been made. This is useful in a hardware implementation such as an FPGA or VLSI implementation, and in a software implementation for example on a DSP, as it allows a designer to know that a result will be available after a particular number of operations or clock cycles (or time).

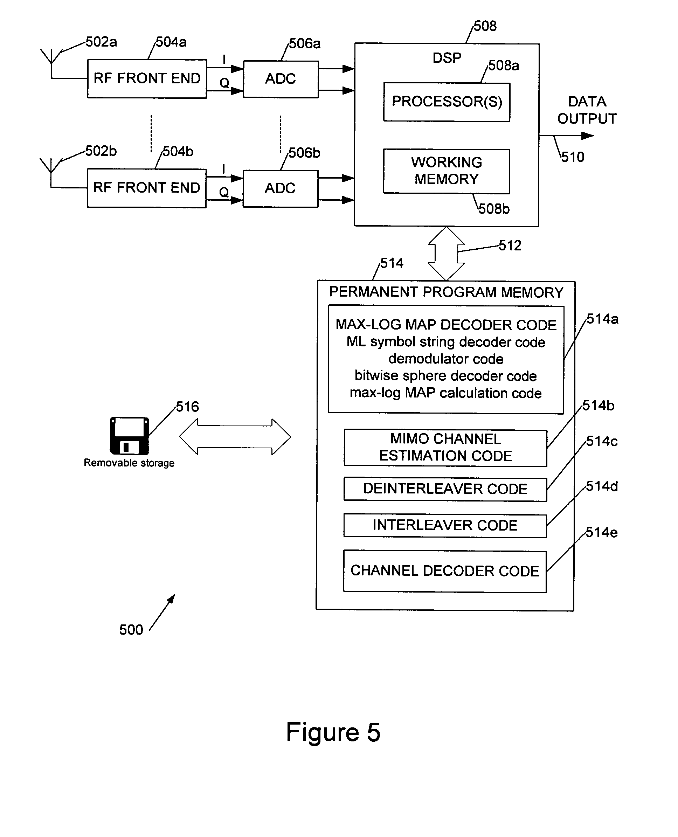

Figure 5b shows a receiver 500 incorporating a decoder configured to implement an embodiment of the above described method.

Receiver 500 comprises one or more receive antennas 502a, b (of which two are shown in the illustrated embodiment) each coupled to a respective rf front end 504a,b, and thence to a respective analogue-to-digital converter 506a,b and to a digital signal processor (DSP) 508. DSP 508 will typically include one or more processors 508a and working memory 508b. The DSP 508 has a data output 510 and an address, data and control bus 512 to couple the DSP to permanent program memory 514 such as flash RAM or ROM. Permanent program memory 514 stores code and optionally data structures or data structure definitions for DSP 508.

As illustrated program memory 514 includes max-log MAP decoder code 514a comprising ML symbol string decoder code (for example sphere decoder comprising code to generate a lattice from a matrix channel estimate, and tree building/searching code), demodulator code, bitwise sphere decoder code, and max-log MAP calculation code. This code, when running on DSP 508, implements corresponding functions as described above. Program memory 514 also includes MIMO channel estimation code 514b to provide a MIMO channel estimate **H**, and, optionally, de-interleaver code 514c, interleaver code 514d, and channel decoder code 514e. Implementations of de-interleaver code, interleaver code, and channel decoder code are well known to those skilled in the art. Optionally the code in permanent program memory 514 may be provided on a carrier such as an optical or electrical signal carrier or, as illustrated in Figure 5, a floppy disk 516.

The data output 510 from DSP 508 is provided to further data processing elements of receiver 500 (not shown in Figure 5) as desired. These may a baseband data processor for implementing higher level protocols.

The receiver front-end will generally be implemented in hardware whilst the receiver processing will usually be implemented at least partially in software, although one or more ASICs and/or FPGAs may also be employed. The skilled person will recognise that all the functions of the receiver could be performed in hardware and that the exact point at which the signal is digitised in a software radio will generally depend upon a cost/complexity/power consumption trade-off.

In other embodiments the decoder may be provided as a signal processing module, for example implementing a soft-in/soft-out space-time decoder.

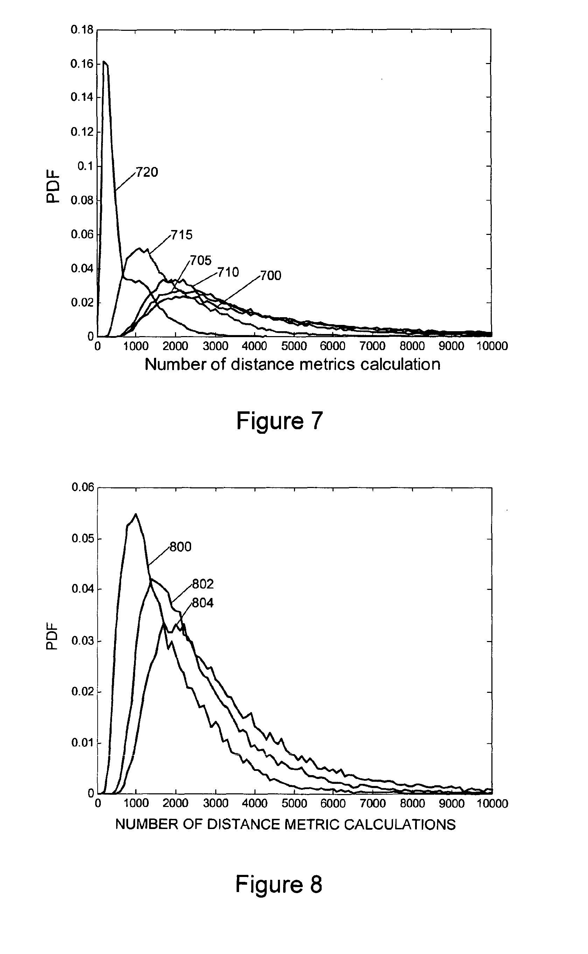

Figure 6 shows bit error rate (BER) against signal to noise power ratio per transmitted information bit (Eb/No) for a half-rate $(5,7)_{oct}$ convolutional coded 4-transmit-antenna - by-4-receive-antenna 16QAM (Quadrature Amplitude Modulation) MIMO system, comparing the performance of a conventional max-log MAP decoder based upon an exhaustive evaluation of all candidates with an implementation of the above described max-log MAP sphere decoder with maximum LLR magnitudes of 100 and 25, over a block-invariant uncorrelated Rayleigh fading channel. The three curves in Figure 6 are co-incident showing that the BER performance of the above described decoder is equivalent to that of an exhaustive search method.

Figure 7 shows the probability density function (PDF) of the number of distance metric calculations performed by an implementation of the above described max-log MAP sphere decoder for a 4x4 16QAM system over an uncorrelated Rayleigh fading channel for various signal to noise power ratios (SNRs) per transmitted information bit (curves 700, 705, 710, 715, and 720 relate to SNRs of 0, 5, 10, 15, and 20dB respectively). The fade is frame-invariant. The maximum LLR magnitude of the max-log-MAP sphere decoder was set to 100. An exhaustive-search based max-log-MAP decoder would require $16^4$ x 4x 2 = 524288 distance metric calculations but the implementation of the above described max-log MAP sphere decoder required at most 10000 distance metrics calculation. Thus embodiments of the above described max-log-MAP sphere decoder can provide a computational complexity reduction of more than 50 times while providing equivalent BER performance.

Figure 8 shows the probability density function (PDF) of the number of distance metric calculations performed an implementation of the above described max-log MAP sphere decoder for a 4x4 16QAM system over an uncorrelated Rayleigh fading channel for maximum LLR magnitudes of 25, 50 and 100 (curves 800, 802, and 804 respectively). The signal to noise power ratio per transmitted information bit was fixed at 10dB. The fade is frame-invariant. The number of distance metric calculations can be seen to be reduced as the maximum LLR magnitude utilized by the max-log-MAP sphere decoder decreases.

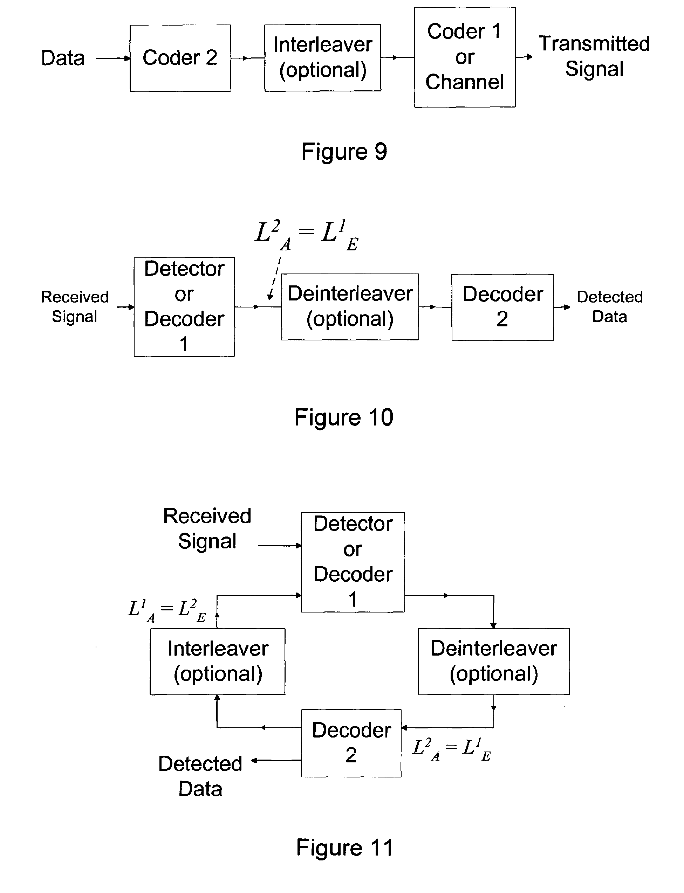

Figure 9 shows a block diagram of a transmitter with concatenated channel encoders; the frequency selective channel can be considered to be an 'encoder'. In Figure 9 Coder 2 may comprise a conventional channel encoder and Coder 1 an STBC coder in combination with the channel.

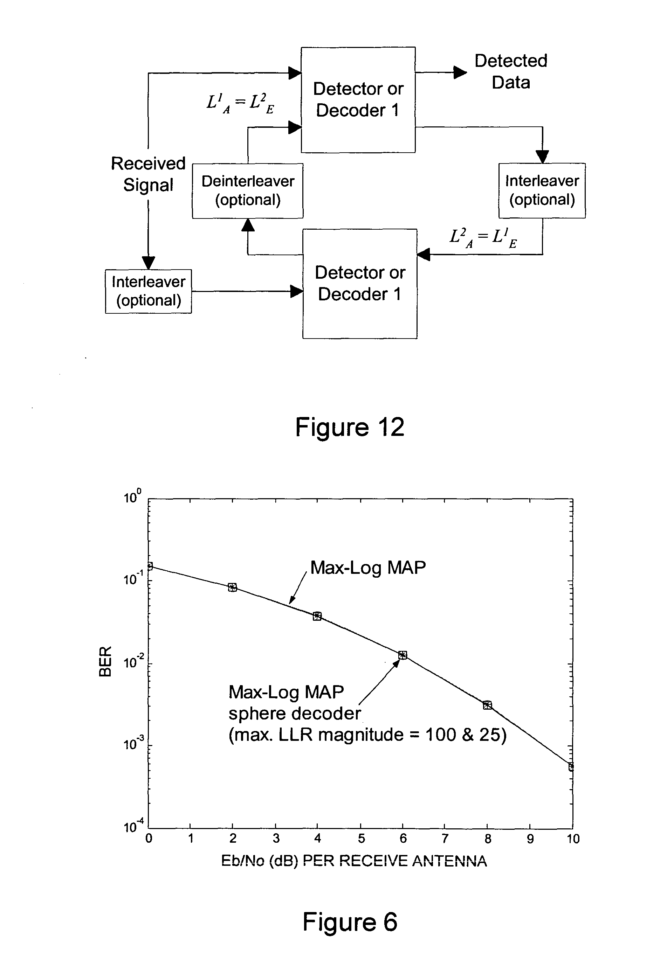

Figure 10 shows a block diagram of a receiver with concatenated channel decoders or detectors, suitable for use with the transmitter of Figure 9. In Figure 10 detector or Decoder 1 may comprise a max-log decoder as described above, and Decoder 2 a conventional channel decoder. Figure 11 shows a block diagram of a variant of the receiver of Figure 10, with concatenated decoders or detectors employing iterative or "turbo" decoding. Figure 12 shows a block diagram of a receiver comprising two instances of Decoder 1, which may comprise, for example, a space-time decoder. In Figure 12 the output of one decoder provides a priori knowledge for the other decoder. In this way the decoder component iteratively exchanges soft information in effect with itself to improve the reliability of the detected data. The received signal is provided to both decoders, optionally (depending upon the interleaving arrangement at the transmitter) interleaved in one case.

In summary, embodiments of the invention provide a low-complexity space-time decoder design based upon the existing sphere decoder procedure to provide Max-log A *Posteriori* (MAP) detection. The complexity of embodiments of the invention is approximately cubic for practical cases whereas that of a conventional max-log-MAP detector increases exponential with the number of jointly detected bits (see, for example, B. Hassibi and H. Vikalo, "On the Expected Complexity of Sphere Decoding", Conference Record of the Thirty-Fifth Asilomar Conference on Signals, Systems and Computers, vol. 2, pp. 1051-1055, 4-7 Nov, 2001). Furthermore the above described techniques facilitate parallel processing for obtaining transmitted bit LLR values, as shown in Figures 2, 3a and 3b.

In embodiments only two candidate possible transmitted symbols are required per transmitted bit in order to obtain max-log-MAP performance as demonstrated by Equation 15. The two candidates may be obtained using bit-wise maximum likelihood sphere decoder. The sphere radius of the bit-wise sphere decoding can be bounded by the maximum LLR magnitude required by the application as shown in Equation 16. Additionally or alternatively the distance metrics of each candidate searched by the maximum likelihood sphere decoder can be used to limit the sphere radius of the bit-wise sphere decoder. The maximum likelihood solution can also be used to provide an initial search radius for the bit-wise sphere decoder as shown in Equation 17.

Embodiments of the invention provide a soft-in/soft-out max-log-MAP decoder which can be used for iterative or concatenated decoding. The use of a soft input in the form of the a priori LLR values is shown in Equations 13 and 14, where it is used to provide the distance metrics for sphere decoding. A soft output may be evaluated using Equation 15. Figures 3a and 3b show how a soft input, together with other parameters, may be used in the search procedure.

Embodiments of the procedure have a reduced memory requirement compared to other techniques since a list of possible transmitted symbols is not required to compute the soft output. By contrast the performance of existing sphere decoders relies on the size of the candidate list - the larger the size of the candidate list, the better the performance of the existing sphere decoder. However, increasing the size of the candidate list also increases the computational complexity of the existing sphere decoder. Thus max-log-MAP performance can be provided with polynomial computational complexity, often sub-cubic, instead of exponential with increasing number of transmit antenna (see, for example, B. Hassibi and H. Vikalo, "Maximum-Likelihood Decoding and Integer Least-Squares: The Expected Complexity", in Multiantenna Channels: Capacity, Coding and Signal Processing, (Editors J. Foschini and S. Verdu), http://www.its.caltech.edu/~hvikalo/dimacs.ns).

Embodiments of the invention have applications in many types of communication system, including MIMO and multiuser systems, for example for wireless computer or phone networking. In multiuser systems, for example, the generator matrix or erquivalent channel matrix may represent a combination of spreading and channel effects for the users (see, for example, L. Brunel, "Optimum Multiuser Detection for MC-CDMA Systems Using Sphere Decoding", 12th IEEE International Symposium on Personal, Indoor and Mobile Radio Communications, Volume 1, 30 Sept.-3 Oct. 2001, pages A-16 -A-20 vol. 1, hereby incorporated by reference).

In other applications the decoder can be applied as a block equaliser for frequency selective fading. Here, the channel model of Equation 5 may be modified to take into account the channel memory as shown below:

$$\breve{\mathbf{r}} = \breve{\mathbf{s}}\breve{\mathbf{H}} + \breve{\mathbf{v}}$$

where

$$\breve{\mathbf{H}} = \begin{bmatrix} \mathbf{H}_1 & \mathbf{H}_2 & \cdots & \mathbf{H}_L & & & & \\ & \mathbf{H}_1 & \cdots & \vdots & \ddots & & & \\ & & \ddots & & & \mathbf{H}_L & & \\ & & & \mathbf{H}_1 & & \vdots & \ddots & \\ & & & & \ddots & & \cdots & \mathbf{H}_L \\ & & & & & \mathbf{H}_1 & \cdots & \mathbf{H}_{L-1} & \mathbf{H}_L \end{bmatrix},$$

$$\breve{\mathbf{r}} = \begin{bmatrix} r_1 & r_2 & \cdots & r_{T+L-1} \end{bmatrix},$$

$$\breve{\mathbf{s}} = \begin{bmatrix} s_1 & s_2 & \cdots & s_T \end{bmatrix},$$

$$\breve{\mathbf{v}} = \begin{bmatrix} v_1 & v_2 & \cdots & v_{T+L-1} \end{bmatrix},$$

and where $T$ is the length of the symbol block being equalized and $\mathbf{H}_i$, $i = 1, ..., L$, is the $i$ th MIMO channel tap. The procedure may then be employed to detect the transmitted block $\breve{\mathbf{s}}$ .

Broadly speaking, any variant of hard detection sphere decoder may be employed in the above described procedure as long as it is able to provide the maximum-likelihood solution and the corresponding distance metrics. Moreover any variant of search procedure, such as those using a genetic algorithm, may replace the hard detection sphere decoder as long as it is able to provide the maximum-likelihood solution and the corresponding distance metrics. Figures 2, 3a and 3b illustrate that any maximum likelihood hard detectors that can provide the relevant distance metrics may be used, and in the foregoing description sphere decoders are merely used by way of example.

Embodiments of the invention can be applied as a channel decoder where the channel encoder can be represented by a linear generator matrix **G**. Examples are block channel codes (see "Digital Communications: Fundamentals and Applications", Bernard Sklar, Prentice Hall International Editions, 1999, 0-13-212713-X) such as Hamming code and Linear Density Parity Check (LDPC) coding where the codeword **x** is generated by the generator matrix **G** from the information bits s through $\mathbf{x} = \mathbf{sG}$, where the vector **s** contains the information bits. For LDPC code, for example, the generator matrix **G** is derived from the parity check matrix **H** to fulfil the orthogonality requirement $\mathbf{GH}^T = \mathbf{0}$ and any legitimate codeword will satisfy the condition $\mathbf{xH}^T = \mathbf{0}$. Here, the information and codeword blocks, **s** and **x**, respectively, are comprised of binary digits, i.e. 1 and 0, and the matrix operations are in a binary field.

Embodiments of the invention provide the maximum likelihood codeword or the soft output based on Equation 10. In an example implementation, the sphere decoder with input **r** and using **G** as the generator matrix, determines the distance between the received signal **r** and each of the possible transmitted codewords in its search. The codeword with the minimum distance is the maximum likelihood codeword. This employs a translation of the information and codeword blocks from a binary field, {0,1} to signed values {-1, +1}, and arithmetic operations are then used.

The skilled person will appreciate that the above described techniques may be employed for example in base stations, access points, and/or mobile terminals. Broadly speaking embodiments of the invention facilitate cheaper receivers without a loss of performance, or equivalently increased data rates without correspondingly increased complexity and cost. Embodiments of the invention may also potentially find application in non-radio systems, for example a disk drive with multiple read heads and multiple data recording layers in effect acting as multiple transmitters.

No doubt many other effective alternatives will occur to the skilled person. It will be understood that the invention is not limited to the described embodiments and encompasses modifications apparent to those skilled in the art lying within the spirit and scope of the claims appended hereto.

**Claims**

1. A decoder for decoding a received signal, said received signal being provided by a transmitted signal comprising a string of symbols sent over a channel, each said symbol comprising one or more bits, said decoder comprising:

   a plurality of maximum likelihood decoders each configured to determine a minimum bit-dependent distance metric for a string of symbols in which a bit has a defined value, said distance metric being dependent upon a distance of said received signal from an estimated received signal determined from said string and a response of said channel; and
   a bit likelihood estimator coupled to each of said maximum likelihood estimators and configured to determine a bit likelihood value for each bit of said string dependent upon said minimum distance metrics.

2. A decoder as claimed in claim 1 wherein a said distance metric is determined responsive to a priori probability values for bits of said string.

3. A decoder as claimed in claim 1 or 2 wherein said maximum likelihood detectors are configured to determine, for each bit of said transmitted string of symbols, a pair of minimum bit-dependent distance metrics, one for each possible value of a said bit.

4. A decoder as claimed in any one of claims 1 to 3 comprising at least one of said maximum likelihood decoders for each bit of said string.

5. A decoder as claimed in claim 4 further comprising two of said maximum likelihood decoders for each bit of said string, one for each logical value of a said bit.

6. A decoder as claimed in any one of claims 1 to 3 further comprising a maximum likelihood detector configured to determine a common, maximum likelihood distance metric for each bit of a maximum likelihood string of symbols.

7. A decoder as claimed in claim 6 wherein said maximum likelihood string of symbols is determined responsive to a priori data relating to said string of symbols.

8. A decoder as claimed in any preceding claim wherein at least some of said maximum likelihood decoders are configured for concurrent operation.

9. A decoder as claimed in any preceding claim wherein said maximum likelihood decoders comprise sphere decoders.

10. A decoder as claimed in claim 9 when dependent upon claim 6, further configured to determine an initial search radius for one or more of said sphere decoders dependent upon said common maximum likelihood distance metric.

11. A decoder as claimed in claim 9 when dependent upon claim 6, further configured to determine an initial search radius for one or more of said sphere decoders dependent upon one or more candidate distance metrics determined during a search for said maximum likelihood string of symbols.

12. A decoder as claimed in claim 9 when dependent upon claim 6, further configured to determine an initial search radius for a sphere decoder configured to minimise a bit-dependent distance metric for a string of symbols in which a bit has a defined value by determining a said distance metric for said maximum likelihood string of symbols with said defined value bit inverted.

13. A decoder as claimed in any one of claims 1 to 12 wherein said channel comprises a MIMO channel, said received signal comprises a signal received at a plurality of receive antennas, and said transmitted symbol string is transmitted from a plurality of transmit antennas.

14. A decoder as claimed in any one of claims 1 to 12 wherein symbols of said transmitted string of symbols are transmitted by a plurality of different users, and wherein said received signal comprises a combination of said symbols transmitted by different users.

15. A method of decoding a received signal, said received signal being provided by a transmitted signal comprising a string of symbols sent over a channel, each said symbol comprising one or more bits, the method employing a plurality of decoders one allocated to each bit of said string, the method comprising:

   determining, for each bit of said string using a decoder allocated to the bit, a minimum bit-dependent distance metric for a string of symbols in which a bit has a defined value, said distance metric being dependent upon a distance of said received signal from an estimated received signal determined from said string and a response of said channel; and
   determining a bit likelihood value for each bit of said string dependent upon said minimum distance metrics.

16. A method as claimed in claim 15 wherein a said distance metric is determined responsive to a priori probability values for bits of said string.

17. A method as claimed in claim 15 or 16 comprising employing two of said decoders for each said bit one for each possible value of said bit, and determining, for each bit of said transmitted string of symbols, a pair of minimum bit-dependent distance metrics, one for each said possible value of a said bit using the two decoders allocated to the bit.

18. A method as claimed in claim 15, 16 or 17, wherein said determining includes determining a common, maximum likelihood distance metric for each bit of a maximum likelihood string of symbols.

19. A method as claimed in claim 18 comprising using at least one further decoder for said common distance metric determining.

20. A method as claimed in any one of claims 15 to 19 wherein said decoders comprise sphere decoders.

21. A method as claimed in any one of claims 15 to 20 wherein at least some of said distance metric determinations are performed in parallel.

22. Processor control code to, when running, implement the method of any one of claims 15 to 21.

**23.** A carrier carrying the processor control code of claim 22.

**24.** A receiver or decoder including the carrier of claim 23.

**25.** A soft-in soft-out decoder for decoding a received signal comprising a set of transmitted symbols, said decoder comprising a plurality of hard decoders each configured to determine a distance metric for a candidate set of said transmitted symbols according to a max-log approximation of a likelihood value of a bit of said set of transmitted symbols, said hard decoders being coupled to an output stage to provide a bit likelihood value for each bit of said set of transmitted symbols responsive to said determined distance metrics.

**26.** A soft-in soft-out decoder as claimed in claim 25 wherein said hard decoders are configured to determine a said distance metric for each logic value of each bit of said set of transmitted symbols.

**27.** A soft-in soft-out decoder as claimed in claim 25 or 26 wherein one of said hard decoders is configured to determine a set of distance metrics, one for each bit of said set of transmitted symbols.

**28.** A soft-in soft-out decoder as claimed in claim 27 wherein said set of distance metrics comprises a single, common distance metric.

**29.** A soft-in soft-out decoder as claimed in any one of claims 25 to 28 wherein at least some of said hard decoders are configured to operate in parallel.

**30.** A soft-in soft-out decoder as claimed in any one of claims 25 to 29 wherein a said distance metric is dependent upon a priori probability data received at a soft input of said decoder.

**31.** A soft-in soft-out decoder as claimed in any one of claims 25 to 30 wherein said hard decoders comprise sphere decoders.

**32.** A soft-in soft-out decoder as claimed in claim 31 wherein one or more of said hard decoders is configured to employ an initial sphere radius or search bound determined responsive to an output from another of said hard decoders.

Figure 1
(PRIOR ART)

MIMO channel

100

EP 1 521 375 A2

$$\mathbf{r}, \mathbf{H}, \sigma$$

$$L_A(\mathbf{x})$$

| Maximum Likelihood Hard Detection for $\mathbf{x} \in X_{1,1}^+$ | Maximum Likelihood Hard Detection for $\mathbf{x} \in X_{n,j}^+$ | Maximum Likelihood Hard Detection for $\mathbf{x} \in X_{n_T,q}^+$ |
|---|---|---|

202a

202b

202c

$$d_{1,1,+}^2 \qquad d_{n,j,+}^2 \qquad d_{n_T,q,+}^2$$

Parallel or serial processing

| Maximum Likelihood Hard Detection for $\mathbf{x} \in X_{1,1}^-$ | Maximum Likelihood Hard Detection for $\mathbf{x} \in X_{n,j}^-$ | Maximum Likelihood Hard Detection for $\mathbf{x} \in X_{n_T,q}^-$ |
|---|---|---|

204a

204b

204c

$$d_{1,1,-}^2 \qquad d_{n,j,-}^2 \qquad d_{n_T,q,-}^2$$

206

Max-Log-MAP calculation
(Equation 15)

Soft Output
$L_P(\mathbf{x})$ or $L_E(\mathbf{x})$

200

# Figure 2

$$\mathbf{r}, \mathbf{H}, \sigma \qquad\qquad\qquad L_A(\mathbf{x})$$

Hard Detection Sphere Decoder
(for $\mathbf{x} \in X$, where $X = X_{n,j}^{+} \bigcup X_{n,j}^{-}$) — 302

$\mathbf{s}_{ML}$ $\qquad$ 303 $\qquad\qquad d_{ML}^2$

Demodulator

$\mathbf{x}_{ML}$

Parallel or serial processing

Hard Detection Sphere Decoder (for $\mathbf{x} \in X_{1,1}^{\neq ML}$) — 304a

304b — Hard Detection Sphere Decoder (for $\mathbf{x} \in X_{n,j}^{\neq ML}$)

304c — Hard Detection Sphere Decoder (for $\mathbf{x} \in X_{n_T,q}^{\neq ML}$)

$d_{1,1,\neq ML}^2$ $\qquad\qquad d_{n,j,\neq ML}^2$ $\qquad\qquad d_{n_T,q,\neq ML}^2$

306 — Max-Log-MAP calculation (Equation 15)

Soft Output
$L_P(\mathbf{x})$ or $L_E(\mathbf{x})$

300

# Figure 3a

$\mathbf{r}, \mathbf{H}, \sigma$     $L_A(\mathbf{x})$

Parallel or serial processing

Hard Detection Sphere Decoder (for $\mathbf{x} \in X_{1,1}^+$)

Hard Detection Sphere Decoder (for $\mathbf{x} \in X_{1,1}^-$)

$\hat{s}^+$    $d_{1,1,+}^2$    $\hat{s}^-$    $d_{1,1,-}^2$

MUX (Choose ML solution, $d_{ML}^2 = \min\{d_{1,1,+}^2, d_{1,1,-}^2\}$)

$\mathbf{s}_M$

Parallel or serial processing

Demodulator    303

$d_{ML}^2$

$\mathbf{x}_{ML}$

Hard Detection Sphere Decoder (for $x \in X_{1,2}^{\neq ML}$)

304

Hard Detection Sphere Decoder (for $\mathbf{x} \in X_{n,j}^{\neq ML}$)

Hard Detection Sphere Decoder (for $\mathbf{x} \in X_{n_T,q}^{\neq ML}$)

$d_{1,1,\neq ML}^2$    $d_{n,j,\neq ML}^2$    $d_{n_T,q,\neq ML}^2$

306    Max-Log-MAP calculation

Soft Output $L_P(\mathbf{x})$ or $L_E(\mathbf{x})$

310

# Figure 3b

Begin *SphereDec*($\mathbf{F}$, $\mathbf{r}$, $L_A(\mathbf{x})$, $\sigma^2$)

N:= the dimension of lattice
bestdist:= initial_bestdist
n:=N
$dist_n$ :=0        newdist:=0
$e_n$:= $\mathbf{r}F$
$\mathbf{slist}_n$:= *SortedList*($e_{n,n}$)
$step_n$:=1
$s_n$:= $\mathbf{slist}_{n,stepn}$
$step_n$:= $step_n$+1
$d$:=($e_{n,n}$- $s_n$)/$f_{n,n}$
Finish:=*FALSE*

## Figure 4

$\mathbf{F} = \mathbf{H}^{-1}$

where $\mathbf{H}$ is the generator matrix of the lattice.

$\mathbf{r}$ is the received signal

$L_A(\mathbf{x})$ is the apriori LLR values

$\sigma^2$ is the noise variance

Finish

*FALSE* ← → *TRUE*

402

newdist:= $dist_n$ + $d^2$ - $L(s_n, L_{A,n}(\mathbf{x}), \sigma^2)$

return
$\mathbf{s'}_{ML}$, $d'_{ML}$

newdist < $\rho^2$ and examined_all == *False*

*TRUE*                                      *FALSE*

n==1

*FALSE* ←   → *TRUE*

**CASE A**

$e_{n-1,i}$ := $e_{n,i}$ - $d f_{i,n}$
i= 1, ..., n-1
n:= n-1
$dist_n$:= newdist
$\mathbf{slist}_n$:= *SortedList*($e_{n,n}$)
$step_k$:= 1
$s_n$:= $\mathbf{slist}_{n, stepn}$
$step_n$:= $step_n$ + 1
$d$:= ($e_{n,n}$- $s_n$)/$f_{n,n}$

**CASE B**

newdist < bestdist

*TRUE*                 *FALSE*

$\mathbf{s'}_{ML}$ := $\mathbf{s}$
$d'_{ML}$ :=bestdist := newdist
$\rho^2$ := bestdist

$step_n$ > M

*TRUE*                 *FALSE*

n := n+1

$step_n$ <= M

*TRUE*                 *FALSE*

$s_n$:= $\mathbf{slist}_{n,stepn}$
$d$:= ($e_{n,n}$ - $s_n$) / $f_{n,n}$

d:= 0

$step_n$:= $step_n$ + 1

**CASE C**

n==N

*FALSE* ←   → *TRUE*

n:= n + 1          Finish := *TRUE*

$step_n$ <= M

*TRUE*                 *FALSE*

$s_n$:= $\mathbf{slist}_{n,stepn}$
$d$:= ($e_{n,n}$ - $s_n$) / $f_{n,n}$

d:= 0

$step_n$:= $step_n$ + 1

400

Figure 5

Figure 7

Figure 8

Data → Coder 2 → Interleaver (optional) → Coder 1 or Channel → Transmitted Signal

## Figure 9

$$L^2_A = L^1_E$$

Received Signal → Detector or Decoder 1 → Deinterleaver (optional) → Decoder 2 → Detected Data

## Figure 10

Received Signal → Detector or Decoder 1

$$L^1_A = L^2_E$$

Interleaver (optional)

Deinterleaver (optional)

Decoder 2

$$L^2_A = L^1_E$$

Detected Data

## Figure 11

Figure 12

Eb/No (dB) PER RECEIVE ANTENNA

Figure 6